Europäisches Patentamt

European Patent Office

Office européen des brevets

(11) Veröffentlichungsnummer: **0 489 381 A1**

## (12) EUROPÄISCHE PATENTANMELDUNG

(21) Anmeldenummer: **91120654.8**

(22) Anmeldetag: **02.12.91**

(51) Int. Cl.5: **C04B 41/87**, H01L 39/24,
C04B 35/00, C23C 4/10,
C23C 4/18

(30) Priorität: **04.12.90 DE 4038564**

(43) Veröffentlichungstag der Anmeldung:
**10.06.92 Patentblatt 92/24**

(84) Benannte Vertragsstaaten:
**AT BE CH DE DK ES FR GB GR IT LI LU NL SE**

(71) Anmelder: **HOECHST AKTIENGESELLSCHAFT**
**Postfach 80 03 20**
**W-6230 Frankfurt am Main 80(DE)**

(72) Erfinder: **Schwarz, Martin, Dr.**

Loreleistrasse 7
**W-6230 Frankfurt/Main 80(DE)**
Erfinder: **Morach, Eugen**
**Höhenweg 6**
**W-6237 Liederbach(DE)**
Erfinder: **Schindler, Hubert**
**Ahornweg 10**
**W-6237 Liederbach(DE)**
Erfinder: **Jünger, Sabine**
**Die Ritterwiesen 8**
**W-6237 Liederbach(DE)**

(54) **Thermisch gespritzte bleihaltige Dickschichten.**

(57) Es wird ein Verfahren zur Herstellung einer supraleitenden Dickschicht (10) auf einem Trägermaterial (9) durch thermisches Spritzen eines Wismut, Blei, Strontium, Calcium und Kupfer in oxydischer Form enthaltenden Pulvers beschrieben. Zunächst wird ein pulverförmiges Ausgangsgemisch bereitet, das eine Zusammensetzung entsprechend der Formel:

$$Bi_{1,90-x} Pb_x Sr_{2-y} Ca_{2,2-z} Cu_{3,5-q} O_v$$

besitzt, in der
$0,1 \leq x \leq 0,7$,
$0 \leq y \leq 0,4$,
$-0,5 \leq z \leq +0,5$,
$0 \leq q \leq 1,2$ ist und
v den aus den Ausgangsprodukten errechneten Sauerstoffgehalt bedeutet. Dann wird das Pulver für eine Zeit von mindestens 1 Stunde auf eine Temperatur von mindestens 750 °C in Sauerstoff enthaltender Atmosphäre erhitzt und wieder abgekühlt. Das so vorreagierte Pulver wird mit Hilfe eines Brenners (1) durch Plasmaspritzen oder durch Flammspritzen in einer Schichtdicke von 0,5 bis 7 mm auf eine thermisch beständige Unterlage aufgetragen. Die aufgetragene Schicht wird dann für eine Zeit von mindestens 40 Stunden bei einer Temperatur von 842 bis 848 °C gesintert. Nach dem Sintern wird auf eine Temperatur von 550 bis 650 °C abgekühlt, für mindestens 20 Minuten bei dieser Temperatur gehalten, wieder auf die Sintertemperatur aufgeheizt und wieder mindestens 20 Minuten bei dieser Temperatur gehalten. Dieser Vorgang wird mindestens zweimal wiederholt und dann wird abgekühlt.

Fig. 1

Die vorliegende Erfindung betrifft kompakte, supraleitende Schichten aus einem Wismut und Blei enthaltenden keramischen Hochtemperatur-Supraleiter und ein Verfahren zu ihrer Herstellung mittels Plasmaspritzen oder Flammspritzen.

Konventionelle metallische Supraleiter zeichnen sich durch niedrige kritische Temperaturen $T_c$ aus, die den Einsatz des teuren Kühlmittels Helium erforderlich machen. Die neuen, hochtemperatur-supraleitenden Materialien auf oxidkeramischer Basis weisen kritische Temperaturen auf, die bereits mit flüssigem Stickstoff als Kühlmittel prinzipiell erreichbar sind.

Dickschichten, das sind Schichten mit einer Dicke von etwa 0,2 bis 10 mm, aus hochtemperatur-supraleitenden Materialien (= HTSL) lassen sich durch thermisches Spritzen rasch und in kompakter Form herstellen. Nachteilig an diesem Verfahren ist, daß das zugeführte oxidkeramische HTSL-Material wegen der hohen Spritztemperaturen partiell aufschmilzt und große Mengen an Sauerstoff sowie seine supraleitenden Eigenschaften ganz oder teilweise verliert. Der fehlende Sauerstoff läßt sich bei geringen Schichtdikken durch eine thermische Nachbehandlung wieder in das Material einzubringen.

Bei der thermischen Nachbehandlung wird die Spritzschicht in Sauerstoffatmosphäre bis zu einer Temperatur aufgeheizt, bei der der Sauerstoff aufgenommen wird, und danach in Sauerstoffatmosphäre langsam abgekühlt. Die thermische Nachbehandlung kann dabei aus mehreren Aufheiz- und Abkühlschritten bestehen. Sie ist zeitaufwendig und kostenintensiv. Außerdem kann die thermische Nachbehandlung zu unerwünschten Verunreinigungen in der Spritzschicht führen, wenn Stoffe aus dem Trägermaterial in die Spritzschicht diffundieren oder mit der Spritzschicht chemisch reagieren.

Es bestand daher die Aufgabe, supraleitende Dickschichten mit möglichst hohen kritischen Temperaturen und hohen supraleitenden Volumenanteilen (gemessen bei T = 77 K, dem Siedepunkt von $N_2$) herzustellen.

Es wurde überraschend gefunden, daß ein Pulver der

Bruttozusammensetzung $Bi_2Sr_2Ca_2Cu_3O_{12-x}$ als Ausgangsprodukt für ein thermisches Spritzverfahren gut geeignet ist, weil die Sprungtemperatur der aufgetragenen und dann getemperten Schicht bei ca. 110 K liegt, d.h. deutlich oberhalb des Siedepunkts von flüssigem $N_2$. Die Herstellung eines zum Spritzen geeigneten Ausgangsmaterials ist beschrieben in der EP-A-327 044. Beispielsweise werden 4,3 mol $Bi_2O_3$, 7 mol $SrCO_3$, 7 mol $CaCO_3$ und 12 mol CuO in einem Achatmörser zerkleinert, gemischt und in einen $Al_2O_3$-Tiegel überführt. Das Produkt wird an Luft auf 800-820°C erhitzt, dort 20 Stunden gehalten, schnell auf Raumtemperatur abgekühlt und im Mörser zerkleinert.

Das thermische Spritzen eines solchen Materials ist beschrieben in der DE-A-39 27 168.

Es wurde nun ein Verfahren zur Herstellung einer supraleitenden Dickschicht auf einem Trägermaterial durch thermisches Spritzen eines Ca, Sr, Bi und Cu und zusätzlich Pb in oxidischer Form enthaltenden Ausgangsgemisches gefunden, das dadurch gekennzeichnet ist, daß man ein pulverförmiges Ausgangsgemisch bereitet, das eine Zusammensetzung entsprechend der Formel

$$Bi_{1.90-x}Pb_xSr_{2-v}Ca_{2.2-z}Cu_{3,5-q}O_v$$

besitzt, in der x zwischen 0,1 und 0,7, y zwischen 0 und 0,4, z zwischen -0,5 und +0,5, g zwischen 0 und 1,2 liegt und v den aus den Ausgangsprodukten errechneten Sauerstoffgehalt bedeutet, man das Pulver für eine Zeit von mindestens 1 Stunde auf eine Temperatur von mindestens 750°C in Sauerstoff enthaltender Atmosphäre erhitzt und wieder abkühlt, man das so vorreagierte Pulver mit Hilfe eines Brenners durch Plasmaspritzen oder durch Flammspritzen in einer Schichtdicke von 0,1 bis 10 mm, insbesondere 0,2 bis 10 mm, vorzugsweise 0,5 bis 7 mm auf eine thermisch beständige Unterlage aufbringt, man die Schicht für eine Zeit von mindestens 40 Stunden bei einer Temperatur von 842 bis 848°C sintert, wobei die Schicht nicht schmelzen darf, man nach diesem Sintern auf eine Temperatur von 550 bis 650°C abkühlt, für mindestens 20 Minuten bei dieser Temperatur hält, wieder auf die Sintertemperatur von 842 bis 848°C aufheizt, man jeweils mindestens 20 Minuten bei dieser Temperatur hält, man diesen Vorgang mindestens zweimal wiederholt und dann abkühlt.

Das Ausgangsgemisch kann die genannten Metalle als Oxyde oder Oxydvorläufer, z.B. als Carbonate, Nitrate oder Oxalate enthalten.

Als Materialien für die thermisch beständige Unterlage (= Substrat) eignen sich insbesondere die Metalle Kupfer oder Silber, Magnesiumoxid, Strontiumtitanat oder Strontiumindat.

Im allgemeinen haftet die durch Plasmaspritzen oder Flammspritzen aufgebrachte Schicht fest auf der Unterlage. Bei geeigneter Form und Art der Unterlage gelingt es jedoch, sie abzulösen. In diesem Fall kann man die reine Schicht, d.h. ohne Unterlage, der weiteren thermischen Behandlung unterwerfen, wobei man zu einer kompakten supraleitenden Schicht ohne Unterlage kommt.

Insbesondere sollte die formgebende Oberfläche aus einem mit dem oxidkeramischen Material nicht reagierenden Werkstoff bestehen und dieser Werkstoff einen thermischen Ausdehnungskoeffizienten aufweisen, der von dem thermischen Ausdehnungskoeffizienten des aufgespritzten oxidkeramischen Materials verschieden ist. Wenn die formgebende Oberfläche während der Beschichtung gekühlt wird und die fertig beschichtete formgebende Oberfläche abgeschreckt wird, läßt sich die Beschichtung als Formkörper von der formgebenden Oberfläche ablösen. Dieses Verfahren ist beschrieben in der deutschen Patentanmeldung P 39 23 008.2 auf die hiermit ausdrücklich Bezug genommen wird.

Zur Vorreaktion kann man im Prinzip das pulverförmige Ausgangsgemisch (in sauerstoffhaltiger Atmosphäre) soweit erhitzen, daß Schmelzen eintritt. Danach muß die Schmelze nach dem Abkühlen wieder pulverisiert werden. Besser ist es jedoch, zur Vorreaktion das pulverförmige Ausgangsgemisch (in Sauerstoff enthaltender Atmosphäre) auf eine Temperatur zu erhitzen, bei der kein Schmelzen eintritt. Das Erhitzen dauert vorteilhafterweise mindestens 5 Stunden. Luft ist gut als sauerstoffhaltige Atmosphäre verwendbar.

Um den Sauerstoffverlust beim thermischen Spritzen gering zu halten ist es vorteilhaft, der Heizflamme des Brenners und/oder dem Spritzstrahl zusätzlich Sauerstoff, Distickstoffoxyd oder Ozon zuzuführen.

Die Sauerstoffanreicherung der Spritzschicht wird bei dieser Ausgestaltung des erfindungsgemäßen Verfahren einfach, schneller und über den Querschnitt der supraleitenden Schicht gleichmäßiger erreicht als beim herkömmlichen thermischen Spritzen ohne zusätzliche Sauerstoff-, Distickstoffoxid- oder Ozonzufuhr und mit anschließender thermischer Nachbehandlung. Das Distickstoffoxid zersetzt sich unter den Bedingungen des thermischen Spritzens zu atomarem, hochreaktivem Sauerstoff und Stickoxiden.

Von den thermischen Spritzverfahren wird beim erfindungsgemäßen Verfahren insbesondere das Flamm- und Plasmaspritzen mit den in DIN 32530 aufgeführten Varianten angewandt. Beim Flammspritzen wird das pulverförmige Material in einer Brenngas-Sauerstofflamme an- oder aufgeschmolzen und durch das expandierende Verbrennungsgas allein oder mit gleichzeitiger Unterstützung durch ein Zerstäubungsgas (z.B. Druckluft) auf das Trägermaterial geschleudert. Dem Brenngas wird Sauerstoff in einer zur Verbrennung des Brenngases ausreichenden Menge zugeführt. Mit Acetylen als Brenngas wird eine Temperatur von maximal 3150°C erreicht. Wesentlich höhere Temperaturen von bis zu 20000°C können beim Plasmaspritzen erreicht werden. Beim Plasmaspritzen wird das pulverförmige Material inner- oder außerhalb des Brenners durch eine Plasmaflamme an- oder aufgeschmolzen, beschleunigt und auf das Trägermaterial geschleudert. Das Plasma wird durch einen Lichtbogen, der zwischen Kathode und Anode brennt, erzeugt. Als Plasmagase werden z.B. Argon, Helium, Stickstoff oder deren Gemische verwendet. Der elektrisch neutrale Plasmastrahl verläßt mit hoher Geschwindigkeit und Temperatur den Plasmabrenner.

Das oxidkeramische Material wird der Heizflamme pulverförmig innerhalb oder bevorzugt außerhalb des Brenners mittels eines Trägergases zugeführt. Das pulverförmige Material wird durch die hohe Temperatur der Heizflamme geschmolzen oder an der Oberfläche der Pulverteilchen angeschmolzen. Das an- oder aufgeschmolzene Material wird als Spritzstrahl auf ein Trägermaterial gesprüht, auf dem es sich als Spritzschicht niederschlägt. Beim thermischen Spritzen verliert das oxidkeramische Material Sauerstoff, was den Verlust oder eine Verschlechterung der supraleitenden Eigenschaften zur Folge hat. Durch das erfindungsgemäße Verfahren wird das oxidkeramische Material entweder nach dem Aufbringen als Schicht durch Sinern und Nachsintern mit Sauerstoff angereichert oder das Material wird im Spritzstrahl bis zum Auftreffen auf dem Trägermaterial wieder mit Sauerstoff angereichert, so daß eine Spritzschicht mit guten supraleitenden Eigenschaften erhalten wird.

Der Heizflamme und/oder dem Spritzstrahl wird der zusätzliche Sauerstoff, das Distickstoffoxid oder das Ozon vorzugsweise außerhalb des Brenners insbesondere am Brennerausgang, zugeführt. Man kann mit Sauerstoff angereicherte Luft verwenden; vorzugsweise wird jedoch reiner Sauerstoff zugeführt. Wird das pulverförmige Material außerhalb des Brenners in die Heizflamme gefördert, so kann der Sauerstoff, das Distickstoffoxid oder das Ozon an derselben Stelle wie das pulverförmige Material zugeführt werden. Es ist jedoch auch möglich, die Sauerstoff-, Distickstoffoxid- oder Ozonzuführung erst anschließend im Spritzstrahl vorzusehen.

Vorzugsweise sind mehrere Zuführungsleitungen oder Düsen um die Heizflamme oder den Spritzstrahl herum angeordnet. Die Zuführung wird vorzugsweise über eine um die Heizflamme oder den Spritzstrahl angeordnete Ringdüse vorgenommen, um dem oxidkeramischen Material gleichmäßig von allen Seiten her Sauerstoff, Distickstoffoxid oder Ozon zuzuführen. Die Zuführungsleitungen oder Düsen sind vorzugsweise so angeordnet, daß der Sauerstoff, das Distickstoffoxid oder das Ozon senkrecht zur Strömungsrichtung des Spritzstrahls zugeführt wird. Bei einer anderen bevorzugten Ausführungsform werden Sauerstoff, Distickstoffoxid oder Ozon in einer mit der Strömungsrichtung des Spritzstrahls einen spitzen Winkel bildenden Strömung zugeführt. Um die Heizflamme und den Spritzstrahl mit dem zugeführten Sauerstoff, Distickstoffoxid oder Ozon zu umhüllen, kann nach dem Austritt des Sauerstoffs, Distickstoffoxids oder Ozons aus der oder den Zuführleitungen oder Düsen ein trichterförmiger Vorsatz um die Heizflamme und/oder den Spritzstrahl angeordnet sein. Z.B. kann an der Ringdüse ein trichterförmiger Vorsatz angeschraubt sein. Dadurch werden Heizflamme und Spritzstrahl durch den Sauerstoff, das Distickstoffoxid oder das Ozon umhüllt. Der Sauerstoff, das Distickstoffoxid oder das Ozon können auch zusammen mit dem pulverförmigen oxidkeramischen Material zugeführt werden, indem der Sauerstoff, das Distickstoffoxid oder das Ozon dem Trägergas zugesetzt werden, mit dem das Material in die Heizflamme des Brenners gefördert werden. Es ist auch möglich, als Trägergas ausschließlich Sauerstoff zu verwenden.

Besonders sauerstoffreiche Spritzschichten, d.h. besonders gute supraleitende Eigenschaften werden erhalten, wenn der Spritzabstand zwischen Brenner und Trägermaterial vergrößert wird. Allerdings kann wegen des mit zunehmendem Abstand sich vergrößernden Spritzverlustes kein zu großer Abstand gewählt werden. Daher wird innerhalb des Bereichs der üblicherweise verwendeten Spritzabstände ein möglichst großer Spritzabstand gewählt.

Diese Variante des chemischen Spritzens wird an Hand der Zeichnung näher beschrieben. In der Zeichnung zeigt:

Fig. 1 einen schematischen Querschnitt durch eine erste Ausführungsform eines Plasmabrenners und den Weg des an- oder geschmolzenen Materials bis zum Auftreffen auf das Trägermaterial,

Fig. 2 einen schematischen Querschnitt durch eine zweite Ausführungsform eines Plasmabrenners und

Fig. 3 einen Schnitt entlang der Linie A - A durch den Plasmabrenner von Fig. 2.

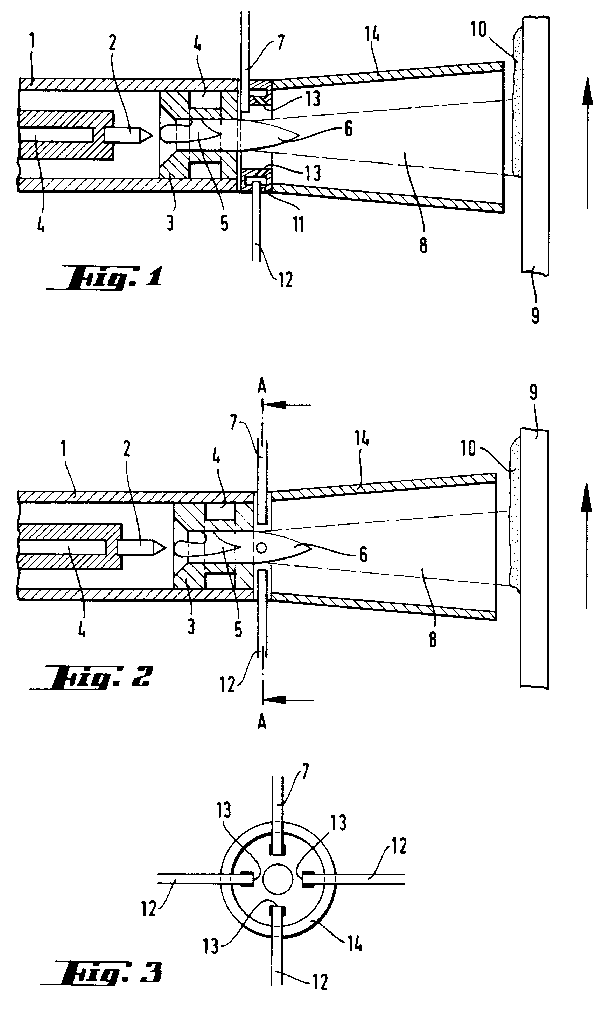

Innerhalb des Plasmabrenners 1 ist eine stabförmige Kathode 2 zentrisch angeordnet. Am Brennerausgang befindet sich eine ringförmige Anode 3. An der Kathode 2 und der Anode 3 sind Kühlwasserkanäle 4 vorgesehen. Zwischen Kathode 2 und Anode 3 brennt ein Lichtbogen hoher Energiedichte. Er gibt den größten Teil seiner Wärmeenergie an das Plasmagas 5 ab, das dadurch teilweise ionisiert wird. Zweiatomige Gase dissoziieren zunächst und geben die dabei aufgenommene Wärmeenergie außerhalb des Plasmabrenners 1 wieder ab. In die aus dem Brenner mit hoher Geschwindigkeit austretende Plasmaflamme 6 wird durch eine Pulverzuführung 7 am Brennerausgang das oxidkeramische Material geblasen. Das Material wird durch die hohe Temperatur der Plasmaflamme 6 an- oder aufgeschmolzen und mit dem Plasmagas als Spritzstrahl 8 auf das Trägermaterial 9 geschleudert, wo es sich als Spritzschicht 10 niederschlägt. Der Pfeil gibt die Vorschubrichtung des Trägermaterials 10 an. In Fig. 1 ist in Spritzrichtung gesehen, hinter der Pulverzuführung 7 eine Ringdüse 11 angeordnet, der durch die Leitung 12 Sauerstoff zugeführt wird. Die Düsenöffnung 13 ist zum Trägermaterial hin gerichtet, so daß der Sauerstoff in einer mit der Strömungsrichtung des Spritzstrahls 8 einen spitzen Winkel bildenden Strömung dem Spritzstrahl 8 und der Plasmaflammenspitze zugeführt wird. An den Brennerausgang schließt sich ein trichterförmiger Vorsatz 14 an, der um den Spritzstrahl 8 herum angeordnet ist.

In der Ausführungsform von Fig. 2 sind die Pulverzuführung 7 und die Sauerstoffzuführung auf der gleichen Höhe am Brennerausgang angeordnet. Der Sauerstoff wird durch drei Leitungen 12 zugeführt. Diese Leitungen 12 sowie die Pulverzuführung 7 sind jeweils in gleicher Ebene senkrecht zur Spritzrichtung um 90° verdreht gegeneinander angeordnet (vgl. Fig. 3). Bei dieser Ausführungsform wird der Sauerstoff in einer jeweils senkrecht zur Strömungsrichtung des Spritzstrahls gerichteten Strömung der Plasmaflamme durch die Düsen 13 zugeführt.

Wie oben erwähnt, soll man die gesinterte Schicht zunächst abkühlen, dann wieder auf die Sintertemperatur von 842 bis 848°C aufheizen und mindestens 20 Minuten bei dieser Temperatur halten. Es hat sich als vorteilhaft erwiesen, wenn man insgesamt 10 bis 40 Stunden, bei dieser Temperatur nachsintert. Bevorzugt sind Gesamtnachsinterzeiten von 15- bis 36 Stunden. Für eine möglichst umfassende Sauerstoffaufnahme ist es ferner vorteilhaft, das wiederholte Aufheizen von 550 bis 650°C auf die Sintertemperatur von 842 bis 848°C in sauerstoffhaltiger Atmosphäre durchzuführen.

Es hat sich gezeigt, daß es vorteilhaft ist, die Proben am Ende der thermischen Nachbehandlung von der Sintertemperatur auf Raumtemperatur langsam abzukühlen, insbesondere mit einer Geschwindigkeit von maximal 100 K/h. Es ist vorteilhaft, wenn das Atomverhältnis Ca:Sr 1:1 beträgt.

Es ist vorteilhaft, das thermische Spritzen und das Sintern bei 842 bis 848°C in Sauerstoff enthaltender Atmosphäre, insbesondere in Luft durchzuführen. Eine reduzierende Atmosphäre ergibt signifikant schlechtere Ergebnisse.

Bei dem wiederholten Erhitzen von 550 bis 650°C auf Sintertemperatur und Wiederabkühlen ergeben sich die besten Ergebnisse mit T = 600°C als unterem Temperaturwert.

Es gelingt, mit dem erfindungsgemäßen Verfahren kompakte supraleitende Schichten mit einer Dicke von 0,1 bis 10 mm, insbesondere 0,2 bis 10 mm, vorzugsweise 0,5 bis 7 mm, und einer Sprungtemperatur von 105 K, herzustellen. Ihre Bruttozusammensetzung entspricht dem Ausgangsoxidgemisch. Der durch Röntgenbeugung bestimmte Phasenanteil an kristallinem $Bi_2Sr_2Ca_2Cu_3O_y$ beträgt mindestens 30 Volumen-%. Dieser Anteil kann bis nahezu 100 Vol.-% ansteigen. Er fällt auf ca 5 %, wenn man das wiederholte Abkühlen auf 550 - 650 und Aufheizen auf 842 - 848°C wegläßt. Diese Schichten sind zunächst mit einer hitzebeständigen Unterlage fest verbunden, auf der sie abgeschieden wurden. Sie lassen sich aber auch isoliert herstellen. Der mit dem Meissner-Effekt bestimmte Volumenanteil bei T = 90 K und H = 15 Gauss beträgt mindestens 50 %.

Die Sprungtemperatur $T_c$ liegt bei 105 - 110 K.

Die Erfindung wird durch die Beispiele näher erläutert.

Beispiel 1

Eine Schicht, die die Oxide von Bi, Pb, Sr, Ca und Cu in den Atomverhältnissen 8:2:8:10:14 enthielt, wurde 7 Tage bei 846°C in Luft gesintert. Anschließend wurde achtmal jeweils auf 600°C abgekühlt und wieder (in Luft) auf 846°C aufgeheizt. Die Probe wurde dem Ofen bei 600°C entnommen.

Ergebnis:

Gemäß Widerstandsmessung und SQUID-Messung liegt die Sprungtemperatur bei 105 K. Die supraleitenden Anteile machen 55 Vol.-% aus (gemessen bei 77 K und 15 Gauss mit dem Meissner-Effekt). Nach Röntgenbeugungsaufnahmen beträgt der Phasenanteil an $Bi_2Sr_2Ca_2Cu_3O_y$ 98 Vol.-%.

Beispiel 2 (Anreicherung des Spritzstrahls mit $O_2$)

Supraleitendes Pulver $Bi_{1.8}Pb_{0.2}Sr_2CaCu_2O_{10-x}$ - (Körnung unter 100 $\mu$m) wurde in eine Plasmaspritzanlage eingebracht, bei der um den Spritzstrahl herum drei Sauerstoffdüsen angeordnet waren, durch die reiner Sauerstoff senkrecht zur Strömungsrichtung des Spritzstrahls im Überschuß zugeführt wurde (vgl. Fig. 2 und 3). Das an- bzw. aufgeschmolzene Material wurde auf eine Trägerplatte aus MgO mit einem Spritzabstand von 130 mm gespritzt. Die gebildete Spritzschicht hatte eine durch Elementaranalyse bestimmte Zusammensetzung von $Bi_{1.8}Pb_{0.2}Sr_2CaCu_2O_{8.4}$ eine Sprungtemperatur Tc = 84 K (AC-Suszeptibilitätsmessung).

**Patentansprüche**

1. Verfahren zur Herstellung einer supraleitenden Dickschicht auf einem Trägermaterial durch thermisches Spritzen eines Wismut, Blei, Strontium, Calcium und Kupfer in oxydischer Form enthaltenden Pulvers, dadurch gekennzeichnet, daß man ein pulverförmiges Ausgangsgemisch bereitet, das eine Zusammensetzung entsprechend der Formel

$$Bi_{1,90-x} Pb_x Sr_{2-y} Ca_{2,2-z} Cu_{3.5-q} O_v$$

besitzt, in der
$0,1 \leq x \leq 0,7$,
$0 \leq y \leq 0,4$,
$-0,5 \leq z \leq +0,5$,
$0 \leq q \leq 1,2$ ist und
v den aus den Ausgangsprodukten errechneten Sauerstoffgehalt bedeutet,
man das Pulver für eine Zeit von mindestens 1 Stunde auf eine Temperatur von mindestens 750°C in Sauerstoff enthaltender Atmosphäre erhitzt und wieder abkühlt, man das so vorreagierte Pulver mit Hilfe eines Brenners durch Plasmaspritzen oder durch Flammspritzen in einer Schichtdicke von 0,5 bis 7 mm auf eine thermisch beständige Unterlage aufbringt, man die Schicht für eine Zeit von mindestens 40 Stunden bei einer Temperatur von 842 bis 848°C sintert, wobei die Schicht nicht schmelzen darf, man nach diesem Sintern auf eine Temperatur von 550 bis 650°C abkühlt, für mindestens 20 Minuten bei dieser Temperatur hält, wieder auf die Sintertemperatur von 842 bis 848°C aufheizt, man jeweils mindestens 20 Minuten bei dieser Temperatur hält, man diesen Vorgang mindestens zweimal wiederholt und dann abkühlt.

2. Verfahren nach Anspruch 1, dadurch gekennzeichnet, daß man das pulverförmige Ausgangsgemisch auf eine Temperatur erhitzt, bei der kein Schmelzen eintritt.

3. Verfahren nach Anspruch 1, dadurch gekennzeichnet, daß man das pulverförmige Ausgangsgemisch bis zum Schmelzen erhitzt und die Schmelze nach dem Abkühlen wieder pulverisiert.

4. Verfahren nach Anspruch 1, dadurch gekennzeichnet, daß man beim wiederholten Aufheizen auf eine Sintertemperatur von 842 bis 848°C Gesamtnachsinterzeiten von 10 bis 40 Stunden, vorzugsweise 15 bis 36 Stunden einhält.

5. Verfahren nach Anspruch 1, dadurch gekennzeichnet, daß das wiederholte Aufheizen auf die Sintertemperatur und Halten bei Sintertemperatur in sauerstoffhaltiger Atmosphäre erfolgt.

6. Verfahren nach Anspruch 1, dadurch gekennzeichnet, daß das Abkühlen von Sintertemperatur auf Raumtemperatur mit einer Geschwindigkeit von max. 100 K/Std. erfolgt.

7. Verfahren nach Anspruch 1, dadurch gekennzeichnet, daß das Pulver des Ausgangsgemischs eine Zusammensetzung von $Bi_{0,8}$ $Pb_{0,2}$ $Sr_{0,8}$ $Ca_1$ $Cu_{1,4}$ in oxydischer Form aufweist.

8. Verfahren nach Anspruch 1, dadurch gekennzeichnet, daß man das Ausgangspulver bis zu 4-mal in Sauerstoff enthaltender Atmosphäre aufheizt und wieder abkühlt.

9. Verfahren zur Herstellung einer supraleitenden Dickschicht auf einem Trägermaterial durch thermisches Spritzen eines Wismut, Blei, Strontium, Calcium und Kupfer in oxydischer Form enthaltenden Pulvers, dadurch gekennzeichnet, daß man ein supraleitendes pulverförmiges Ausgangsgemisch bereitet, das eine Zusammensetzung entsprechend der Formel

$$Bi_{1,90-x} \ Pb_x \ Sr_{2-y} \ Ca_{2,2-z} \ Cu_{3.5-q} \ O_v$$

besitzt, in der
$0,1 \leq x \leq 0,7$,
$0 \leq y \leq 0,4$,
$-0,5 \leq z \leq +0,5$,
$0 \leq q \leq 1,2$ ist und
v den aus den Ausgangsprodukten errechneten Sauerstoffgehalt bedeutet, daß man das Pulver für eine Zeit von mindestens 1 Stunde auf eine Temperatur von mindestens 750° C in Sauerstoff enthaltender Atmosphäre erhitzt und wieder abkühlt, daß man das so behandelte Pulver mit Hilfe eines Brenners durch Plasmaspritzen oder durch Flammspritzen in einer Schichtdicke von 0,5 bis 7 mm auf eine thermisch beständige Unterlage aufbringt, und daß man der Heizflamme des Brenners und/oder dem Spritzstrahl zusätzlich Sauerstoff, Distickstoffoxid oder Ozon zuführt.

10. Verfahren nach Anspruch 9, dadurch gekennzeichnet, daß Sauerstoff, Distickstoffoxid oder Ozon im Überschuß zugeführt wird.

Fig. 1

Fig. 2

Fig. 3

Europäisches
Patentamt

**EUROPÄISCHER TEILRECHERCHENBERICHT** Nummer der Anmeldung

der nach Regel 45 des Europäischen Patentübereinkommens für das weitere Verfahren als
europäischer Recherchenbericht gilt

EP  91 12 0654

## EINSCHLÄGIGE DOKUMENTE

| Kategorie | Kennzeichnung des Dokuments mit Angabe, soweit erforderlich der maßgeblichen Teile | Betrifft Anspruch | KLASSIFIKATION DER ANMELDUNG (Int. Cl.5) |
|---|---|---|---|
| Y | EP-A-0 324 121 (NKK CORPORATION) <br> * Zusammenfassung; Ansprüche 1,3; Seite 3, Zeile 44 - Seite 4, Zeile 2; Seite 4, Zeile 31 - Seite 5, Zeile 3; Beispiel 2 * | 1-3,5-6 ,8-10 | C 04 B   41/87 <br> H 01 L   39/24 <br> C 04 B   35/00 <br> C 23 C    4/10 <br> C 23 C    4/18 |
| A | --- | 7 | |
| Y | EP-A-0 327 044 (HOECHST AG) <br> * Zusammenfassung; Ansprüche 1,21,26-28,31,34-39; Beispiel 7; Seite 3, Zeile 18 - Seite 4, Zeile 3; Seite 6, Zeilen 24-38 * <br> --- | 1-3,5-6 ,8-10 | |
| A | WORLD PATENT INDEX LATEST, Derwent Publications Ltd, London, GB, Woche 9025, & JP-A-2 125 854 (KAGAKU GIJUTSU-CHO KINZ) 14-05-1990 <br> * Zusammenfassung * <br> ---                              -/- | 1-3,6,8 | |

RECHERCHIERTE
SACHGEBIETE (Int. Cl.5)

C 04 B
H 01 L
C 23 C

## UNVOLLSTÄNDIGE RECHERCHE

Nach Auffassung der Recherchenabteilung entspricht die vorliegende europäische Patentanmeldung den Vorschriften des Europäischen patentübereinkommens so wenig, daß es nicht möglich
ist, auf der Grundlage einiger Patentansprüche sinnvolle Ermittlungen über den Stand der
Technik durchzuführen.
Vollständig recherchierte Patentansprüche:
Unvollständig recherchierte Patentansprüche:      1-10
Nicht recherchierte Patentansprüche:
Grund für die Beschränkung der Recherche:

Es besteht ein Zusammenhanglosigkeit
zwischen Ansprüche 1 und 7.
Darüberhinaus lassen sich die Ausführungsbeispiele der Erfindung dem Anspruch 1 nicht
unterordnen. Daher sind die Ansprüche nicht
klar.

| Recherchenort | Abschlußdatum der Recherche | Prüfer |
|---|---|---|
| DEN HAAG | 19-02-1992 | NORGREN-OLSSON |

KATEGORIE DER GENANNTEN DOKUMENTEN

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes
    Dokument

Europäisches
Patentamt **EUROPÄISCHER TEILRECHERCHENBERICHT**    Nummer der Anmeldung

EP   91 12 0654

| | EINSCHLÄGIGE DOKUMENTE | | | KLASSIFIKATION DER ANMELDUNG (Int. Cl.5) |
|---|---|---|---|---|
| **Kategorie** | **Kennzeichnung des Dokuments mit Angabe, soweit erforderlich der maßgeblichen Teile** | **Betrifft Anspruch** | | |
| A | JOURNAL OF THE AMERICAN CERAMIC SOCIETY, Bd. 73, Nr. 4, April 1990, Columbus, US; Seiten 889-892; F.-H. CHEN et al: "Formation of High-Tc Superconducting Bi-Pb-Sr-Ca-Cu oxide films by spray pyrolysis of an oxalate suspension" <br> * Spalte 1, Zeile 1 - Spalte 2, Zeile 13; Spalte 3, Zeile 14 - Spalte 4, Zeile 3; Tabelle 1 * <br> --- | 1,7 | | |
| A | CHEMICAL ABSTRACTS, Band 111, 1989, Columbus, Ohio, US; Zusammenfassung Nr. 204412F, T. ARIMA et al: "Optical spectra of bismut lead strontium calcium copper oxide" <br> * Seite 644; Spalte 2; Zusammenfassung <br> * & JAPANESE JOUNAL OF APPLIED PHYSICS, Teil 2, Bd. 28, Nr. 6, 1989, Otsu, Japan, Seiten 913-915 <br> --- | 1,7,9 | **RECHERCHIERTE SACHGEBIETE (Int. Cl.5)** | |
| A | EP-A-0 326 944   (THE PERKIN-ELMER CORPORATION) <br> * Zusammenfassung; Ansprüche 1-2,4,7; Seite 3, Zeilen 13-34; Seite 5, Zeilen 27-41; Seite 6, Zeile 28 - Seite 7, Zeile 20; Seite 8, Zeilen 28-39 * <br> ----- | 1-2,9-10 | | |

EPO FORM 1503 03.82 (P0412)